(19) **Europäisches Patentamt**

**European Patent Office**

**Office européen des brevets**

(11) **EP 0 821 487 B1**

(12) **EUROPÄISCHE PATENTSCHRIFT**

(45) Veröffentlichungstag und Bekanntmachung des Hinweises auf die Patenterteilung:
**27.09.2000 Patentblatt 2000/39**

(51) Int Cl.[7]: **H03L 7/08**, H03L 7/10

(21) Anmeldenummer: **97112448.2**

(22) Anmeldetag: **21.07.1997**

(54) **Phasenregelkreis mit Technologiekompensation**

PLL circuit with technology compensation

Boucle verrouillée en phase avec compensation de technologie

(84) Benannte Vertragsstaaten:
**DE FR GB IT**

(30) Priorität: **22.07.1996 DE 19629550**

(43) Veröffentlichungstag der Anmeldung:
**28.01.1998 Patentblatt 1998/05**

(73) Patentinhaber: **SIEMENS AKTIENGESELLSCHAFT**
**80333 München (DE)**

(72) Erfinder:
- **Werker, Heinz**
  **82024 Taufkirchen (DE)**
- **Scheideler, Dirk**
  **81825 München (DE)**
- **Eichler, Thomas**
  **82008 Unterhaching (DE)**

(56) Entgegenhaltungen:
**US-A- 5 363 419        US-A- 5 491 439**

- **MANEATIS J G: "LOW-JITTER AND PROCESS-INDEPENDENT DLL AND PLL BASED ON SELF-BIASED TECHNIQUES" IEEE INTERNATIONAL SOLID STATE CIRCUITS CONFERENCE, Bd. 39, Februar 1996, Seite 130/131, 430 XP000685564**
- **REZA SHARIATDOUST ET AL: "A LOW JITTER 5 MHZ TO 180 MHZ CLOCK SYNTHESIZER FOR VIDEO GRAPHICS" PROCEEDINGS OF THE CUSTOM INTEGRATED CIRCUITS CONFERENCE, BOSTON, MAY 3 - 6, 1992, Nr. CONF. 14, 3.Mai 1992, INSTITUTE OF ELECTRICAL AND ELECTRONICS ENGINEERS, Seiten 24.2.1-24.2.5, XP000340948**

**Beschreibung**

Die Erfindung betrifft einen Phasenregelkreis mit nacheinander geschalteten Phasendetektor, Schleifenfilter und Oszillator.

Bei einem Phasenregelkreis (Phase-Locked Loop, PLL) wird ein Oszillator auf die Phase eines Eingangssignals auf synchronisiert. Die grundsätzliche Anordnung einer PLL ist beispielsweise aus Tietze, Schenk, Electronic Circuits, 1991, insbesondere Figur 27.20, bekannt.

Die charakteristischen Größen einer PLL sind die Eigenfrequenz und die Dämpfung. Bei einer PLL, die als integrierte Schaltungen realisiert ist, sind diese Größen unter anderem von der Technologie abhängig und können somit in einem Bereich von zirka $\pm50$ % schwanken. Diese Ungenauigkeiten führen zum Beispiel bei der Frequenzsynthese mit PLL zu einem erhöhten Jitter oder zur Instabilität der Schaltung. Der kritische Punkt ist hierbei die Dämpfung. Die Dämpfung sollte mindestens 0,7 betragen, um die Stabilität des Regelkreises zu gewährleisten. Mit den üblichen technologieabhängigen Toleranzen, müßte die Dämpfung auf das 2- bis 4-fache des normalen Wertes überdimensioniert werden.

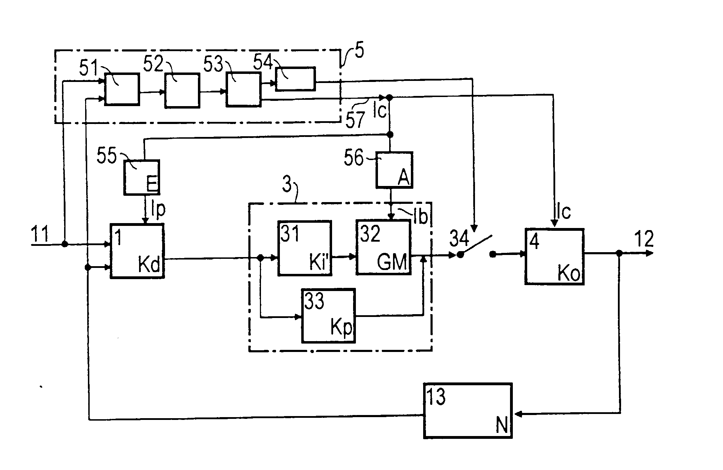

Ein Lösungsansatz nach dem Stand der Technik ist zum Beispiel aus aus dem US-Patent 5,491,439 bekannt. Hier ist in Figur 1 eine gattungsgemäße PLL angegeben. Nach der Arbeitspunkteinstellung wird hier durch Stromumschaltung die Dämpfung herabgesetzt, was zu einem geringeren Jitter führt.

Aufgabe der Erfindung ist es, eine PLL anzugeben, bei der Ungenauigkeiten infolge von Schwankungen von Technologieparametern verringert werden.

Aus Maneatis J. G., "Low-Jitter and Process-Independent DLL and PLL based on Self-Biased-Techniwues", IEEE International Solid State Circuits Conderence, Bd. 39, Februar 1996, Seiten 130 bis 131, 430 XP000685564, ist ein Phasenregelkreis bekannt, der eine Einrichtung aufweist, die den Arbeitspunkt des Phasenregelkreises so einstellt, daß die Dämpfung und die Eigenfrequenz des Phasenregelkreises von Technologieschwankungen unabhängig sind. Dazu weist der Phasenregelkreis Ladungspumpen auf, die von einem Bias-Strom eines Bufferverstärkers versorgt werden. Als Schleifenfilter weist der Phasenregelkreis eine symmetrische Last auf. Dabei wird gezeigt, daß die Dämpfung und Eigenfrequenz des Phasenregelkreises von dem Verhältnis einiger Technologieparameter abhängt. Technologieschwankungen beeinflussen dabei die Verhältnisse nur in sehr geringem Maße.

Die Aufgabe wird durch eine PLL mit Technologiekompensation gemäß Patentanspruch 1 gelöst. Insbesondere ist hierfür eine Grobregeleinrichtung vorgesehen. Ausgestaltungen und Weiterbildungen des Erfindungsgedanken sind Gegenstand der Unteransprüche.

Die erzielten Vorteile bestehen insbesondere darin, daß durch die erfindungsgemäße PLL Schwankungen der Eigenfrequenz und der Dämpfung deutlich verringert werden. Da Technologieschwankungen bereits durch eine Grobregelung kompensiert werden, läßt sich das Filter der PLL mit einer kleineren Integrationskapazität realisieren. Dadurch wird zusätzlich Chipfläche gespart.

Die Erfindung wird nachfolgend anhand des in der einzigen Figur der Zeichnung dargestellten Ausführungsbeispiels näher erläutert. Es zeigt:

Figur 1 das Blockschaltbild einer erfindungsgemäßen PLL mit Grobregelung.

Figur 1 zeigt eine erfindungsgemäße PLL, die einen ersten Phasendetektor 1, einen Schleifenfilter 3, einen Oszillator 4 und einen Teiler 13 in Reihe aufweist. Der Verstärkungsfaktor des Phasendetektors hat den Wert Kd, der Verstärkungsfaktor des Oszillators hat den Wert Ko und der Teilerfaktor beträgt N. Das vom Teiler heruntergeteilte Oszillatorausgangssignal 12 wird zusammen mit einem PLL-Eingangssignal 11 in den ersten Phasendetektor eingekoppelt. Das Ausgangssignal des ersten Phasendetektors steuert den Schleifenfilter an. Das Ausgangssignal des Schleifenfilters wird bei geschlossenem Schalter 34 in den Oszillator 4 eingekoppelt.

Im ersten Phasendetektor wird die Frequenz des PLL-Eingangssignals mit der Frequenz des von dem Teiler heruntergeteilten Oszillatorausgangssignals verglichen. Ein dem Frequenzunterschied entsprechendes Signal wird vom ersten Phasendetektor ausgangsseitig dem Oszillator zugeführt. Die ausgangsseitigen Stromimpulse des Phasendetektors vergrößern oder verkleinern je nach Phasenlage von PLL-Eingangssignal und Oszillatorausgangssignal das Potential am Schleifenfilter.

Das Schleifenfilter enthält insbesondere ein Tiefpaßfilter. Der Tiefpaßfilter weist einen Integralteil und einen Proportionalteil auf. Die Filterkonstanten von Integralteil und Proportionalteil haben die Werte $Ki=Ki'*GM$ bzw. Kp, wobei GM ist der Verstärkungsfaktor des Operationsverstärkers ist. Der Integralanteil des Tiefpaßfilters weist im wesentlichen eine Integrationskapazität 31 mit nachgeschaltetem Operationsverstärker 32 auf. Der Operationsverstärker arbeitet als Spannungs-Strom-Umsetzer. In der integrierten Schaltungstechnik ist es schwierig, den Widerstand des Proportionalteiles 33 des Tiefpaßfilters aufgrund von Technologieschwankungen ausreichend genau zu realisieren. Aus diesem Grund wird ein dem Proportionalteil 33 des Tiefpaßfilters entsprechender Strom zum Ausgangsstrom des Spannungs-Strom-Umsetzers addiert. Der sich daraus ergebende Strom wird in den Oszillator eingekoppelt. Als Oszillator wird ein stromgesteuerter Oszillator, insbesondere ein Ringoszillator, verwendet. Die Elemente des Ringoszillators, insbesondere Transistoren und Kapazitäten, sowie der Verstärkungsfaktor GM des Operationsverstärkers sind stark technologieabhängig.

Zusätzlich wird das vom Teiler heruntergeteilte Oszillatorausgangssignal zusammen mit dem PLL-Eingangssignal einer Grobregeleinrichtung 5 zugeführt. Die Grobregeleinrichtung wird bevorzugt als digitale PLL realisiert. Die Grobregeleinrichtung enthält einen geschalteten zweiten Phasendetektor 51, AufwärtsAufwärts-/Abwärtszähler 52 und Digital-Analog-Umsetzer 53 in Reihe. Das Ausgangssignal 57 mit dem Stromwert Ic des Digital-Analog-Umsetzers wird in den Oszillator 4 eingekoppelt. Außerdem wird das Ausgangssignal 57 über zwei Multiplikationseinheiten 55 und 56 in den ersten Phasendetektor 1 bzw. in den Schleifenfilter 3 eingekoppelt. Zusätzlich enthält die Grobregeleinrichtung 5 einen Einrast-Detektor (Locked-Detector) 54, der dem Aufwärts-/Abwärtszähler nachgeschaltet ist und der ausgangsseitig den Schalter 34 ansteuert. Die Funktion des Schalters wird bevorzugt durch ein Filter mit Enable-Funktion realisiert.

Im zweiten Phasendetektor werden die Frequenzen des PLL-Eingangssignals und des von dem Teiler heruntergeteilten Oszillatorausgangssignals miteinander verglichen. Ausgangsseitig liefert der zweite Phasendetektor ein dem Frequenzunterschied proportionales Ausgangssignal. Dieses Ausgangssignal wird einem Aufwärts-/Abwärtszähler zugeführt. Der Aufwärts-/Abwärtszähler weist dem Frequenzunterschied einen entsprechenden Zahlenwert zu. Dieser Zahlenwert wird einem Digital-Analog-Umsetzerzugeführt. Das Ausgangssignal des Digital-Analog-Umsetzer wird in den Oszillator eingekoppelt. Der in den Oszillator eingekoppelte Strom Ic stellt die Sollfrequenz des stromgesteuerten Oszillators ein. Dieser Zählerstand ist damit ein Maß für die Streuung der technologieabhängigen Parameter des stromgesteuerten Oszillators und kann bei Bedarf zusätzlich beim Test der Schaltung zur Auswertung herangezogen werden.

Während der Grobregelung ist der Schalter offen und somit die Feinregelung deaktiviert. In der unmittelbaren Startphase ist der Phasenregelkreis noch nicht eingeschwungen. Das bedeutet, die Frequenzunterschiede bzw. die Phasenlagen von Eingangssignal und Ausgangssignal der PLL haben sich noch nicht auf einen konstanten Wert stabilisiert. In diesem Fall ist der Aufwärts-/Abwärtszähler noch nicht eingerastet. Der dem Aufwärts-/Abwärtszähler nachgeschaltete Einrast-Detektor stellt fest, ob der Aufwärts-/Abwärtszählers eingerastet ist. Der Einrast-Detektor sendet dann ein Steuersignal zum Schließen des Schalters. In der nachfolgenden Betriebsphase ist der Aufwärts-/Abwärtszähler eingerastet, daß heißt der Zahlenwert des Aufwärts-/Abwärtszählers ändert sich nicht mehr. In der Betriebsphase ist der Arbeitspunkt der PLL bzw. die Sollfrequenz für den Oszillator eingestellt. Durch das Schließen des Schalters wird die Feinregelung eingeschaltet. Die Feinregelung regelt geringe Schwankungen wie zum Beispiel Temperaturschwankungen und Schwankungen der Versorgungsspannung aus.

In der ersten Multiplikationseinrichtung 55 wird der Ausgangsstrom 57 der Grobregeleinrichtung mit einem Faktor E multipliziert. Der Faktor E entspricht dem Verhältnis zwischen dem Steuerstrom des Oszillators und dem Ausgangsstrom des ersten Phasendetektors. Ausgangsseitig von der ersten Multipliktionseinrichtung wird ein Strom mit dem Stromwert Ip dem ersten Phasendetektor zugeführt. In der zweiten Multiplikationseinrichtung 56 wird der Ausgangsstrom der Grobregeleinrichtung mit einem Faktor A multipliziert. Der Faktor A entspricht dem Verhältnis zwischen dem Steuerstrom des Oszillators und dem Biasstrom des Operationsverstärkers. Ausgangsseitig von der zweiten Multipliktionseinrichtung wird ein Strom mit dem Stromwert Ib dem Operationsverstärkers des Schleifenfilters zugeführt.

Durch die Grobregelung wird damit eine Arbeitspunkteinstellung durchgeführt, die die einzelnen Ströme in einem festen Verhältnis zueinander variiert und somit die Dämpfung und die Eigenfrequenz der PLL nicht beeinflußt.

Während der Startphase der PLL ist nur die Grobregelung aktiv. Der aktuelle Arbeitspunkt wird somit abhängig von der Technologie, der momentanen Temperatur und der Versorgungsspannung für die nachfolgend arbeitende Feinregelung eingestellt. Die Grobregelung arbeitet dabei als digitale PLL. Die in der nachfolgenden Betriebsphase aktive Feinregelung hat die Aufgabe spätere Temperatur- und Versorgungsspannungsschwankungen auszuregeln. Da Technologieschwankungen bereits durch die Grobregelung kompensiert werden, ist es möglich, den Tiefpaßfilter mit einer kleineren Integrationskapazität zu realisieren, als es sonst nötig wäre. Dadurch wird zusätzlich Chipfläche gespart.

Nachfolgend ist eine Herleitung angegeben, wie die Dämpfung und die Eigenfrequenz durch die oben beschriebene Schaltungstechnik unabhängig von Technologieparametern eingestellt wird. Allgemein gilt für die Dämpfung D und die Eigenfrequenz wn:

$$wn = \sqrt{\frac{Kd \times Ko \times Ki}{N}} \qquad (1)$$

$$D = \frac{Kp}{2}\sqrt{\frac{Kd \times Ko}{Ki \times N}} \qquad (2).$$

Hierbei ist Kd der Verstärkungsfaktor des Phasendetektors, Ko ist der Verstärkungsfaktor des Oszillators, Ki und Kp sind der integrale und der proportionale Filterfaktor und N ist der Teilerfaktor. Weiterhin werden folgende Konstanten bzw. Verhältnisse wie folgt definiert:

$$Kd = \frac{Ip}{2\pi} \qquad (3)$$

$$Ki = \frac{GM}{Cfil} = \frac{\sqrt{Ib \times Kt \times F}}{Cfil} \qquad (4)$$

$$Ko = \frac{1}{2 \times Co} \sqrt{\frac{Kt}{Ic}} \qquad (5)$$

$$Cfil = Co \times B = \frac{\sqrt{Ic \times Kt}}{wo} B \qquad (6)$$

$$Ib = \frac{Ic}{A} \qquad (7)$$

$$Ip = \frac{Ic}{E} \qquad (8).$$

Kt ist die Transistorkonstante, F ist das Weiten/Längenverhältnis der Transistoren des Oszillators und des Tiefpaßfilters, Cfil ist die Integrationskapazität des Filters, Co ist die Lastkapazität des Oszillators, B ist das Verhältnis von Lastkapazität des Oszillators und Integrationskapazität des Filters, wo ist die Oszillatorfrequenz.
Mit den Gleichungen 1 bis 8 ergibt sich für die Eigenfrequenz und für die Dämpfung:

$$wn = \frac{wo}{2} \sqrt{\frac{1}{\pi BEN}} \sqrt[4]{\frac{F}{A}} \qquad (9)$$

$$D = \frac{Kp}{4} \sqrt{\frac{B}{\pi EN}} \sqrt[4]{\frac{A}{F}} \qquad (10).$$

Die Eigenfrequenz ist jetzt abhängig von der Oszillatorfrequenz wo, dem Weiten/Längenverhältnis der Transistoren des Oszillators und des Tiefpaßfilters (F), dem Verhältnis zwischen dem Steuerstrom des stromgesteuerten Oszillators und dem Ausgangsstrom des ersten Phasendetektors (E), dem Verhältnis zwischen dem Steuerstrom des stromgesteuerten Oszillators und dem Biasstrom des Tiefpaßfilters (A), dem Verhältnis der Lastkapazität des Oszillators zur Integrationskapazität des Filters (B) und dem Teilerfaktor im Rückkoppelungszweig der PLL (N). Die Dämpfung ist abhängig von den oben beschriebenen Verhältnissen und dem Proportionalfaktor Kp des Tiefpaßfilters. Oszillatorfrequenz, Proportionalfaktor und Teilerfaktor sind fest definiert. Die Verhältnisse zwischen den Strömen bzw. die Geometrien lassen sich in der integrierten Schaltungstechnik mit sehr hoher Genauigkeit einstellen. Durch diese Grobregelung wird eine Einstellung durchgeführt, so daß die einzelnen Ströme in einem festen Verhältnis zueinander variiert werden und damit die Dämpfung und die Eigenfrequenz der PLL nicht beeinflussen.

**Patentansprüche**

1. Phasenregelkreis, der als Teil einer integrierten Schaltung ausgeführt ist, mit einem geschalteten ersten Phasendetektor (1), einem Schleifenfilter (3) und einem Oszillator (4) in Reihe, gekennzeichnet durch eine Grobregeleinrichtung (5), deren Ausgangssignal (57) in den Oszillator (4) eingekoppelt wird, sowie über eine erste Multiplikationseinrichtung (55) in den ersten Phasendetektor (1) und über eine zweite Multiplikationseinrichtung (56) in den Schleifenfilter (3) eingekoppelt wird und einen Schalter (34), der zwischen den Schleifenfilter (3) und den Oszillator (4) geschaltet ist und von einem Steuersignal der Grobregeleinrichtung (5) so gesteuert wird, daß während der Startphase des Phasenregelkreises der Schalter (34) geöffnet ist und während der Betriebsphase des Phasenregelkreises der Schalter (34) geschlossen ist, wobei die Grobregeleinrichtung (5) während der Startphase des Phasenregelkreises den Arbeitspunkt so einstellt, daß die Dämpfung und die Eigenfrequenz des Phasenregelkreises unabhängig von Schwankungen der Technologieparameter ist.

2. Phasenregelkreis nach Anspruch 1,
   **dadurch gekennzeichnet,**
   daß die Grobregeleinrichtung (5) durch einen digitalen Phasenregelkreis realisiert wird.

3. Phasenregelkreis nach einem der Ansprüche 1 bis 2,
   **dadurch gekennzeichnet,**
   daß die Grobregeleinrichtung (5) einen zweiten Phasendetektor (51), einen Aufwärts-/Abwärtszähler (52) und einen Digital-Analog-Wandler (53) enthält, die einander in Reihe geschaltet sind, und daß der Reihenschaltung die erste (55) und zweite (56) Multiplikationseinrichtung nachgeschaltet ist.

4. Phasenregelkreis nach einem der Ansprüche 1 bis 3,
   **dadurch gekennzeichnet,**
   daß das Eingangssignal (11) des Phasenregelkreises und das Ausgangssignal (12) des Phasenregelkreises gleichzeitig in den ersten Phasendetektor (1) und in die Grobregeleinrichtung (5) eingekoppelt werden.

5. Phasenregelkreis nach einem der vorhergehenden Ansprüche,
   **dadurch gekennzeichnet,**
   daß das Ausgangssignal (57) der Grobregeleinrichtung (5) in der ersten Multiplikationseinrichtung (55) multipliziert wird mit einem ersten Faktor (E), der dem Verhältnis zwischen dem Steuerstrom des Oszillator (4) und dem Ausgangsstrom des ersten Phasendetektors (1) entspricht und das Ausgangssignal (57) in der zweiten Multiplikationseinrichtung (56) multipliziert wird mit einem zweiten Faktor (A), der dem Verhältnis zwischen dem Steuerstrom des Oszillators (4) und dem Bias-strom des Schleifenfilters (3) entspricht.

6. Phasenregelkreis nach einem der vorhergehenden Ansprüche,
   **dadurch gekennzeichnet,**
   daß die Grobregeleinrichtung (5) eine dem Aufwärts-/ Abwärtszähler (52) nachgeschaltete Einrast-Detektor-Einrichtung (54) enthält, die den Schalter (34) ansteuert.

7. Phasenregelkreis nach Anspruch 6,
   **dadurch gekennzeichnet,**
   daß der Schalter (34) durch ein Filter mir Enable-Funktion realisiert wird.

8. Phasenregelkreis nach einem der Ansprüche 6 oder 7,
   **dadurch gekennzeichnet,**
   daß während der Startphase des Phasenregelkreises der zählerstand des Aufwärts-/Abwärtszählers (52) nicht eingerastet ist und die Einrast-Detektor-Einrichtung (54) ein Steuersignal zum Öffnen des Schalters (34) aussendet und daß während der Betriebsphase des Phasenregelkreises der Zählerstand des Aufwärts-/Abwärtszählers (52) eingerastet ist und die Einrast-Detektor-Einrichtung (54) ein Steuersignal zum Schließen des Schalters (34) aussendet.

9. Phasenregelkreis nach einem der vorhergehenden Ansprüche,
   **dadurch gekennzeichnet,**
   daß der Oszillator (4) ein stromgesteuerter Oszillator, insbesondere ein Ringoszillator, ist.

10. Phasenregelkreis nach Anspruch 9,
    **dadurch gekennzeichnet,**
    daß in den stromgesteuerten Oszillator (4) ein Strom eingekoppelt wird, der sich aus der Addition des Ausgangsstromes einer Proportionalteileinrichtung (33) und des Ausgangsstromes eines Operationsverstärkers (32) ergibt, wobei das Schleifenfilter (3) die Proportionaleinrichtung (33) und den Operationsverstärker (32) aufweist.

11. Phasenregelkreis nach einem der vorhergehenden Ansprüche,

**dadurch gekennzeichnet,**
daß das Schleifenfilter (3) ein Tiefpaßfilter ist.

**Claims**

1.  Phase-locked loop which is designed as part of an integrated circuit, having a switched first phase detector (1), a loop filter (3) and an oscillator (4) in series, characterized by a coarse control device (5) whose output signal (57) is coupled into the oscillator (4), as well as being coupled into the first phase detector (1) via a first multiplier (55) and coupled into the loop filter (3) via a second multiplier (56), and a switch (34) which is connected between the loop filter (3) and the oscillator (4) and is controlled by a control signal of the coarse control device (5) such that during the starting phase of the phase-locked loop the switch (34) is open, and during the operating phase of the phase-locked loop the switch (34) is closed, the coarse control device (5) setting the operating point during the starting phase of the phase-locked loop such that the attenuation and the natural frequency of the phase-locked loop are independent of fluctuations in the technological parameters.

2.  Phase-locked loop according to Claim 1, characterized in that the coarse control device (5) is implemented by a digital phase-locked loop.

3.  Phase-locked loop according to one of Claims 1 to 2, characterized in that the coarse control device (5) contains a second phase detector (51), an up-/down-counter (52) and a digital-to-analogue converter (53) which are connected to one another in series, and in that the first (55) and second (56) multipliers are connected downstream of the series circuit.

4.  Phase-locked loop according to one of Claims 1 to 3, characterized in that the input signal (11) of the phase-locked loop and the output signal (12) of the phase-locked loop are simultaneously coupled into the first phase detector (1) and into the coarse control device (5).

5.  Phase-locked loop according to one of the preceding claims, characterized in that the output signal (57) of the coarse control device (5) is multiplied in the first multiplier (55) by a first factor (E) which corresponds to the ratio between the control current of the oscillator (4) and the output current of the first phase detector (1), and the output signal (57) in the second multiplier (56) is multiplied by a second factor (A) which corresponds to the ratio between the control current of the oscillator (4) and the bias current of the loop filter (3).

6.  Phase-locked loop according to one of the preceding claims, characterized in that the coarse control device (5) contains a latching detector device (54) which is connected downstream of the up-/down-counter (52) and drives the switch (34).

7.  Phase-locked loop according to Claim 6, characterized in that the switch (34) is implemented by a filter with an enable function.

8.  Phase-locked loop according to either of Claims 6 or 7, characterized in that during the starting phase of the phase-locked loop the counter reading of the up-/down-counter (52) is not latched, and the latching detector device (54) emits a control signal for opening the switch (34), and in that during the operating phase of the phase-locked loop the counter reading of the up-/down-counter (52) is latched and the latching detector device (54) emits a control signal for closing the switch (34).

9.  Phase-locked loop according to one of the preceding claims, characterized in that the oscillator (4) is a current-controlled oscillator, in particular a ring oscillator.

10. Phase-locked loop according to Claim 9, characterized in that coupled into the current-controlled oscillator (4) is a current which results from the addition of the output current of a proportional divider (33) and the output current of an operational amplifier (32), the loop filter (3) having the proportional divider (33) and the operational amplifier (32).

11. Phase-locked loop according to one of the preceding claims, characterized in that the loop filter (3) is a low-pass filter.

**Revendications**

1. Boucle à verrouillage de phase réalisée comme élément d'un circuit intégré, comprenant un premier détecteur de phase (1) couplé, un filtre de boucle (3) et un oscillateur (4) en série, caractérisée par un dispositif de réglage grossier (5) dont le signal de sortie (57) est appliqué à l'oscillateur (4) ainsi que, à travers un premier dispositif multiplicateur (55), au premier détecteur de phase (1) et, à travers un deuxième dispositif multiplicateur (56), au filtre de boucle (3), et par un commutateur (34) qui est monté entre le filtre de boucle (3) et l'oscillateur (4) et qui est commandé par un signal de commande du dispositif de réglage grossier (5), de telle sorte que pendant la phase de démarrage de la boucle à verrouillage de phase, le commutateur (34) est ouvert et que pendant la phase de fonctionnement de la boucle à verrouillage de phase, le commutateur (34) est fermé, le dispositif de réglage grossier (5) ajustant le point de fonctionnement pendant la phase de démarrage de la boucle à verrouillage de phase de manière à ce que l'amortissement et la fréquence propre de la boucle à verrouillage de phase soient indépendants de variations des paramètres technologiques.

2. Boucle à verrouillage de phase selon la revendication 1, caractérisée en ce que le dispositif de réglage grossier (5) est réalisé par une boucle à verrouillage de phase numérique.

3. Boucle à verrouillage de phase selon l'une des revendications 1 ou 2, caractérisée en ce que le dispositif de réglage grossier (5) comporte un deuxième détecteur de phase (51), un incrémenteur/décrémenteur (52) et un convertisseur numérique-analogique (53) montés en série, et en ce que le premier (55) et le deuxième (56) dispositif multiplicateur sont montés à la suite du montage en série.

4. Boucle à verrouillage de phase selon l'une des revendications 1 à 3, caractérisée en ce que le signal d'entrée (11) de la boucle à verrouillage de phase et le signal de sortie (12) de la boucle à verrouillage de phase sont appliqués simultanément au premier détecteur de phase (1) et au dispositif de réglage grossier (5).

5. Boucle à verrouillage de phase selon l'une des revendications précédentes, caractérisée en ce que le signal de sortie (57) du dispositif de réglage grossier (5) est multiplié dans le premier dispositif multiplicateur (55) par un premier facteur (E) qui correspond au rapport entre le courant de commande de l'oscillateur (4) et le courant de sortie du premier détecteur de phase (1) et en ce que le signal de sortie (57) est multiplié dans le deuxième dispositif multiplicateur (56) par un deuxième facteur (A) qui correspond au rapport entre le courant de commande de l'oscillateur (4) et le courant de polarisation du filtre de boucle (3).

6. Boucle à verrouillage de phase selon l'une des revendications précédentes, caractérisée en ce que le dispositif de réglage grossier (5) comporte un dispositif détecteur de verrouillage (54) monté à la suite de l'incrémenteur/décrémenteur (52), qui commande le commutateur (34).

7. Boucle à verrouillage de phase selon la revendication 6, caractérisée en ce que le commutateur (34) est réalisé par un filtre ayant une fonction autorisation.

8. Boucle à verrouillage de phase selon l'une des revendications 6 ou 7, caractérisée en ce que pendant la phase de démarrage de la boucle à verrouillage de phase, l'état de compteur de l'incrémenteur/décrémenteur (52) n'est pas verrouillé et le dispositif détecteur de verrouillage (54) émet un signal de commande pour ouvrir le commutateur (34), et en ce que pendant la phase de fonctionnement de la boucle à verrouillage de phase, l'état de compteur de l'incrémenteur/décrémenteur (52) est verrouillé et le dispositif détecteur de verrouillage (54) émet un signal de commande pour fermer le commutateur (34).

9. Boucle à verrouillage de phase selon l'une des revendications précédentes, caractérisée en ce que l'oscillateur (4) est un oscillateur commandé par courant, en particulier un oscillateur annulaire.

10. Boucle à verrouillage de phase selon la revendication 9, caractérisée en ce que l'oscillateur commandé par courant (4) se voit appliquer un courant qui résulte de l'addition du courant de sortie d'un dispositif diviseur proportionnel (33) et du courant de sortie d'un amplificateur opérationnel (32), le filtre de boude (3) présentant ledit dispositif proportionnel (33) et ledit amplificateur opérationnel (32).

11. Boude à verrouillage de phase selon l'une des revendications précédentes, caractérisée en ce que le filtre de boucle (3) est un filtre passe-bas.